# EUROPEAN PATENT APPLICATION

(11) **EP 1 608 210 A1**
(43) Date of publication of application: **21.12.2005**
(21) Application number: 05105312.2
(22) Date of filing: 16.06.2005
(51) Int. Cl.: H05K 3/28, H05K 3/00

(54) **Wiring Board, Magnetic Disc Apparatus, and Method of Manufacturing Wiring Board**

(30) Priority: 18.06.2004 JP 2004181181
(71) Applicant: KABUSHIKI KAISHA TOSHIBA, Tokyo 105-8001 (JP)
(72) Inventor: Muro, Kiyomi, 105-8001, Tokyo (JP)
(74) Representative: Henkel, Feiler & Hänzel

(57) **Abstract**

Disclosed is a wiring board including a first polyimide layer (12) of heat-cured photosensitive polyimide, a copper layer pattern (15) formed by growing an electrolytic copper plating layer on the polyimide layer, and a second polyimide layer (16) of heat-cured photosensitive polyimide, the second polyimide layer covering the copper layer pattern. Also, disclosed is a magnetic disc apparatus including this wiring board (37), a head carriage (33) having an electric connection to the wiring board and having a head (34) mounted thereon to perform input/output of electric signals transmitted bilaterally via the connection, and a magnetic disc (31) on which reading/writing of magnetic information are performed by the head mounted on the head carriage.

## Description

### CROSS-REFERENCE TO RELATED APPLICATIONS

This application is based upon and claims the benefit of priority from the prior Japanese Patent Application No. 2004-181181, filed on June 18, 2004; the entire contents of which are incorporated herein by reference.

### BACKGROUND

### 1. FIELD OF THE INVENTION

The present invention relates to a wiring board and a method of manufacturing the same, as well as a magnetic disc apparatus having the wiring board and, more particularly, to a wiring board that is preferable for a small-sized magnetic disc apparatus and a method of manufacturing the same, as well as a magnetic disc apparatus having such a wiring board.

### 2. DESCRIPTION OF THE RELATED ART

Along with the sophistication in performance and the reduction in size and weight of portable devices and electronic devices, miniaturization is required also in a magnetic disc apparatus as a representative apparatus for storing a large volume of digital information. For such a small magnetic disc apparatus, the size of a disc enclosure itself accommodating a disc and so on is small, and each wiring board equipped therein is also required to respond to miniaturization. Additionally, not only to respond to miniaturization, it is also important to ensure reliability.

Some of wiring boards used and disposed inside the disc enclosures are functionally required to have flexibility. As a representative of such a wiring board, there is a wiring board as a cable extendingly provided on a carriage in order to exchange signals with a head and the like on the carriage. Since the carriage is displaced with the head over a magnetic disc, according thereto a state of bending of the wiring board which is extendingly provided changes drastically. Therefore, as for the reliability thereof, it is necessary to be considered more carefully than in a case of normal use inwhich the state of bending does not change. Incidentally, stiffness is preferable to be small in order to avoid being a disturbance element (load) as far as possible in displacement of the carriage.

As for miniaturization, it is necessary to respond to a trend that a pitch between lands in a component mounting region of the wiring board that is used is becoming increasingly narrower. If the pitch is narrow, a faulty connection easily occurs at a time of component mounting and reliability may be impaired. In this way, in the small-sized magnetic disc apparatus, two opposite things are always required of the wiring board used therein, to respond to miniaturization and to ensure reliability. Incidentally, as an example that could be used as such a flexible wiring board having a narrow pitch and high reliability, there is one described in Patent Document 1 stated below. As for the content of the patent document, the flexible wiring board features a cover lay in particular, and there is referred to the improvement of physical, chemical, and mechanical properties of the cover lay.

### [Patent Document 1] Japanese Patent Laid-Open (Kokai) Application No. 2003-149804

### SUMMARY

The present invention is made in consideration of the circumstances described above, and in a wiring board and a method of manufacturing the same as well as a magnetic disc apparatus having the wiring board, it is an object of the present invention to provide: a wiring board which can be applied to the magnetic disc apparatus and is capable of promoting miniaturization and ensuring reliability; a method of manufacturing the same; and a magnetic disc apparatus having such a wiring board.

A wiring board according to an aspect of the present invention includes: a first polyimide layer of heat-cured photosensitive polyimide; a copper layer pattern formed by growing an electrolytic copper layer on the first polyimide layer; and a second polyimide layer of heat-cured photosensitive polyimide, the second polyimide layer covering the formed copper layer pattern.

More specifically, in this wiring board, an insulating layer on the copper layer pattern is formed by heat-curing the photosensitive polyimide. Therefore, a fine pattern is easily formed by a photo mask, and a polyimide layer can be formed, for example, between narrow pitch lands. Hereby, faulty connections at the time of component mounting can be reduced. Additionally, the entire wiring board is thin, and so a degree to become a load in bending is smaller. Further, since a structure is simple, the structure is hard to be destroyed. Consequently, this wiring board is suitable to be applied to a magnetic disc apparatus to realize miniaturization and to ensure reliability.

A magnetic disc apparatus according to an aspect of the present invention includes: a wiring board which has a first polyimide layer of heat-cured photosensitive polyimide, a copper layer pattern formed by growing an electrolytic copper layer on the first polyimide layer, and a second polyimide layer of heat-cured photosensitive polyimide, the second polyimide layer covering the formed copper layer pattern; a head carriage having an electric connection to the wiring board and having a head mounted thereon to perform input/output of electric signals transmitted bilaterally via the connection; and a magnetic disc on which reading/writing of magnetic information are performed by the head mounted on the head carriage.

More specifically, this magnetic disc apparatus uses the above-described wiring board as a wiring board as a cable to be connected to the head carriage. Therefore, as the disc apparatus, miniaturization is realized and reliability is ensured.

A method of manufacturing the wiring board according to an aspect of the present invention includes: applying first liquid photosensitive polyimide on a stainless steel layer by coating; forming a first polyimide layer of a predetermined shape pattern by exposing, developing, and heat-curing the applied first liquid photosensitive polyimide; growing an electrolytic copper plating layer of a predetermined pattern on the formed first polyimide layer; applying second liquid photosensitive polyimide on the first polyimide layer including the electrolytic copper plating layer of the predetermined pattern by coating; and forming a second polyimide layer of a predetermined pattern by exposing, developing, and heat-curing the applied second liquid photosensitive polyimide so that a part of the electrolytic copper plating layer is exposed.

This manufacturing method is an example of manufacturing the above-described wiring board.

According to the present invention, there can be provided a wiring board applied to a magnetic disc apparatus and capable of promoting miniaturization and ensuring reliability, a method of manufacturing the same, and a magnetic disc apparatus having such a wiring board.

### BRIEF DESCRIPTION OF THE DRAWINGS

Fig. 1A, Fig. 1B, Fig. 1C, Fig. 1D, and Fig. 1E are process drawings showing a manufacturing process of a wiring board according to one embodiment of the present invention by schematic cross sections.
Fig. 2A, Fig. 2B, Fig. 2C, Fig. 2D, and Fig. 2E are drawings continued from Fig. 1E, and are process drawings showing the manufacturing process of the wiring board according to the one embodiment of the present invention by schematic cross sections.
Fig. 3 is a top view showing an aspect in which the wiring board according to the one embodiment of the present invention is used in a magnetic disc apparatus.
Fig. 4 is a top view showing a structure of a head carriage communication wiring board shown in Fig. 3.
Fig. 5 is a top view enlargedly showing a structure of a component mounting region in the head carriage communication wiring board shown in Fig. 4.

### DETAILD DESCRIPTION

### (Explanation of Embodiments)

Embodiments of the present invention will be described with reference to the drawings, but these drawings are presented only for the illustrative purpose and in no respect, are intended to Iimit the present invention.

As a form of an embodiment of the present invention, there may be further included a stainless steel layer provided on a surface of the first polyimide layer different from a side having the copper layer pattern. This is a structure in which the stainless steel layer is included as a mechanical reinforcing layer.

As another form, the second polyimide layer may have plural openings to expose a part of the copper layer pattern. This is a case that the openings are used, for example, as lands for mounting components.

As still another form, the plural openings of the second polyimide layer respectively may be openings for separate electrical nodes in the copper layer pattern. More specifically, since the openings can be provided by a fine pattern, the opening is provided for each electrically separate node of the copper layer pattern. Hereby, short-circuit faults of solder which may occur between those exposed nodes can be effectively reduced.

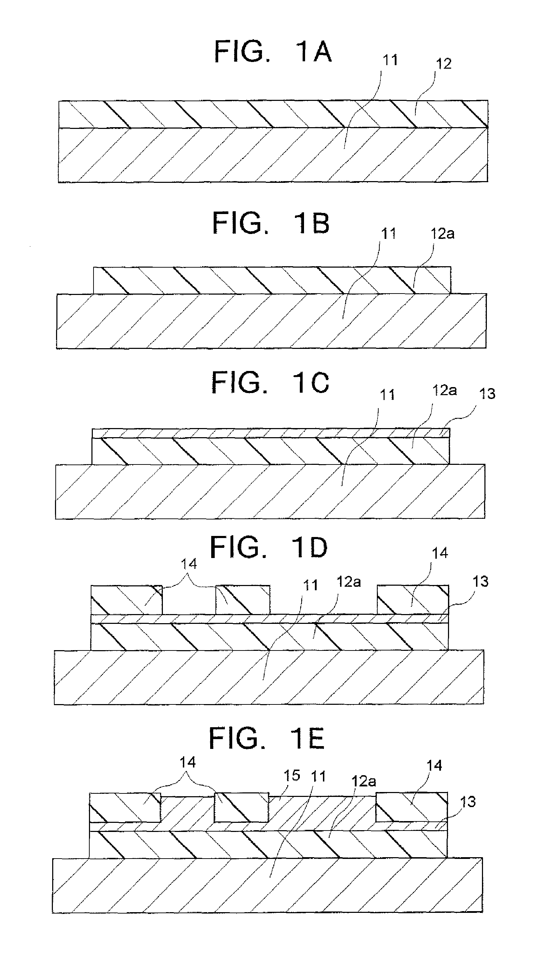

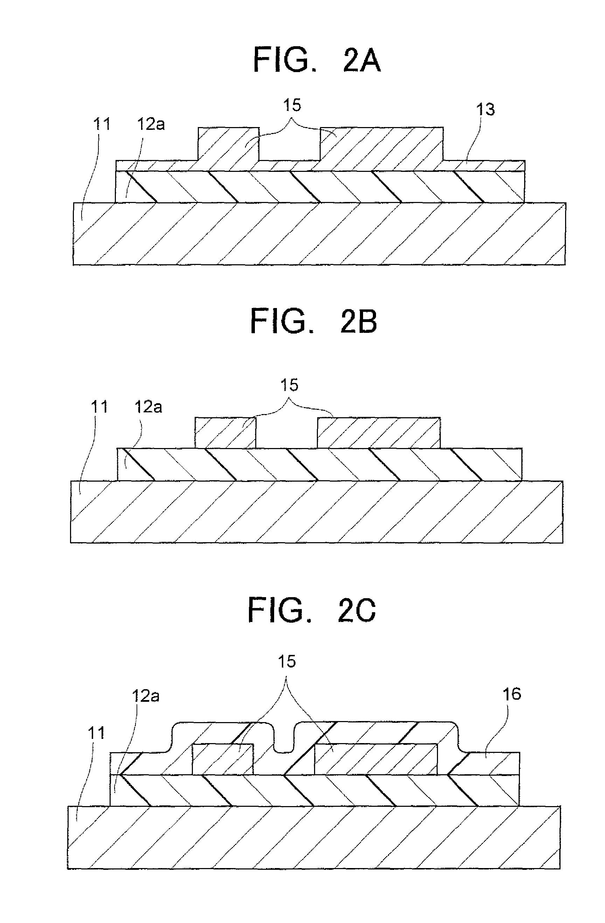

Based on the above, embodiments of the present invention will be hereinafter described with reference to the drawings. Fig. 1A to Fig. 1E as well as Fig. 2A to Fig. 2E are process drawings showing a manufacturing process of a wiring board according to one embodiment of the present invention by way of schematic cross sections. Fig. 2A to Fig. 2E are drawings continued from Fig. 1E, steps progress respectively in sequence from A in the drawings. In these drawings, the same or substantially the same portions are represented by the same reference numerals and symbols.

In order to manufacture the wiring board of the present embodiment, first, using a prepared stainless steel plate, while the stainless steel plate is passed between two rollers having a predetermined gap, for example, liquid photosensitive polyimide is applied on an entire surface thereof. Hereby, as shown in Fig. 1A, there is obtained a photosensitive polyimide layer 12 with a predetermined thickness applied on the stainless steel layer 11. The stainless steel layer 11 also functions as a base material (base) at a time of manufacturing this wiring board, and thickness thereof is, for example, from about 25 µm to about 100 µm. Thickness of the photosensitive polyimide layer 12 is, for example, about 10 µm.

As shown in Fig. 1B, the photosensitive polyimide layer 12 obtained by applying is patterned in a predetermined pattern so that a patterned polyimide layer 12a is obtained. For this, for example, a photo mask of a predetermined pattern is disposed on the photosensitive polyimide layer 12 and then predetermined light is irradiated thereon, so that exposure of the photosensitive polyimide layer 12 is performed. Thereafter, the photo mask is removed and respective development and heat-curing processes are performed on the exposed photosensitive polyimide layer 12. The patterned polyimide layer 12a obtained hereby functions as a base layer in the wiring board, and a shape thereof is determined by the photo mask so that one having a fine portion can be easily manufactured.

As shown in Fig. 1C, a seed layer (for example, chromium for a base, and copper thereon) 13 for electrolytic copper plating is formed in thickness of, for example, the chromium being about 0.01 µm to about 0.05 µm and thickness of the copper being about 0.1 µm to about 0.5 µm, on the entire surface of the patterned polyimide layer 12a. Then, as shown in Fig. 1D, a resist 14 of a predetermined pattern is formed on the formed seed layer 13. The predetermined pattern here is a pattern for forming an electric conductor (copper layer) pattern. The resist 14 can be formed using, for example, a known photo resist (in the form of liquid or sheet: the one in the form of sheet is advantageous for a fine pattern).

A step of electrolytic copper plating is performed using the seed layer 13 as an electric current supply channel, and as shown in Fig. 1E, an electrolytic copper plating layer 15 is grown on portions without the resist 14 on the seed layer 13. Thickness to be obtained after growing is, for example, about 12 µm. When the electrolytic copper plating layer 15 is formed, the resist 14 is removed as shown in Fig. 2A, and in addition, as shown in Fig. 2B, the seed layer 13 is removed by wet etching, for example. Hereby, an electric conductor (copper layer) pattern by the electrolytic copper plating layer 15 is obtained. After this, nickel plating (not shown) for corrosion control may be applied on a surface of the electrolytic copper plating layer 15.

The electric conductor pattern obtained here can be used as a wiring pattern or a land for mounting components. For example, when the electric conductor pattern is used as the wiring pattern, a cross section thereof is close to rectangular in shape as shown in the drawing, and therefore there is an advantage that the wiring pattern can have higher allowable current density than a wiring pattern formed by etching if they have the same areas in plan views.

As shown in Fig. 2C, on the entire surface of patterned polyimide layer 12a including the electrolytic copper plating layer 15, liquid photosensitive polyimide is applied as in applying and forming of the photosensitive polyimide layer 12 so that a photosensitive polyimide layer 16 is obtained. For the photosensitive polyimide layer 16, the same composition as that for the photosensitive polyimide layer 12 can be used. Formed thickness of the photosensitive polyimide layer 16 is, for example, about 5 µm.

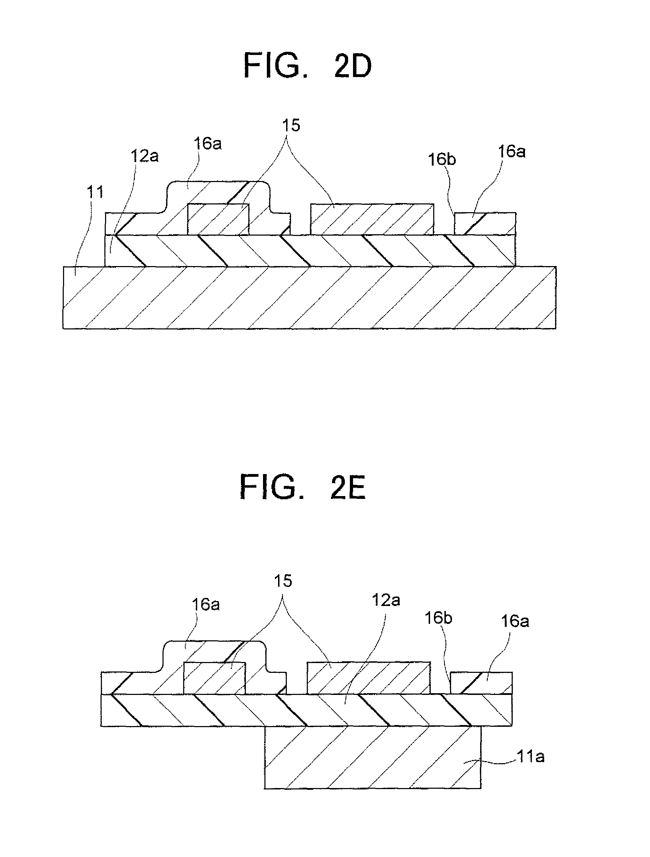

As shown in Fig. 2D, the photosensitive polyimide layer 16 obtained by applying is patterned to a predetermined pattern so that a patterned polyimide layer 16a is obtained. For this, for example, a photo mask of a predetermined pattern is disposed on the photosensitive polyimide layer 16 and predetermined light is irradiated so that exposure of the photosensitive polyimide layer 16 is performed. Thereafter, the photo mask is removed and respective development and heat-curing processes are performed on the exposed photosensitive polyimide layer 16. The patterned polyimide layer 16a obtained here functions as a cover layer in the wiring board.

By the photosensitive polyimide layer 16 being made to the predetermined pattern, as shown in the drawing, a part of the electrolytic copper plating layer 15 becomes in an exposed state by an opening 16b of the polyimide layer 16a. The electrolytic copper plating layer 15 of this exposed part can be used as, for example, a component mounting land or a connecting electrode to a connector. Since a pattern of the opening is determined by the photo mask, one having a fine portion can also be easily manufactured.

As shown in Fig. 2E, the stainless steel layer 11 is patterned to a predetermined pattern so that a patterned stainless steel layer 11a is obtained. For this, for example, a resist of a predetermined pattern is formed on the stainless steel layer 11 (opposite side of the polyimide layer 12a side), and with this resist being a mask the stainless steel layer 11 is wet etched by, for example, iron chloride. This resist can be formed using, for example, a known photo resist (in the form of liquid or sheet: the one in the form of sheet is advantageous for a fine pattern). The stainless steel layer 11a left in the patterning functions as a mechanical reinforcing layer, for example, in this wiring board structure.

The wiring board manufactured according to the above is constituted, except the stainless steel layer 11a, with the polyimide layer 12a as the base layer, the electrolytic copper plating layer 15 as the electric conductor (copper layer) pattern, and the polyimide layer 16a as the cover layer, and hence the structure thereof is very simple. In particular, since an adhesive resin layer is not required between the upper and lower polyimide layers and the electric conductor pattern, a temperature range for use is not limited by a glass transition point of the adhesive resin layer, and the wiring board has a wide usable temperature. According to an experiment, a large characteristic change is not recognized until the parts of polyimide layers 12a, 16a show weight reduction at 450°C.

Since the polyimide layer 16a as the cover layer in particular is obtained by way of patterning by exposure and development, formation accuracy thereof is very high. Therefore, there is no need for high bonding accuracy that is required in a conventionally well-known method, such as a method of bonding a polyimide layer on which an opening is formed in advance with bonding resin. Also, productivity thereof is higher than that in a case of forming the opening by laser machining after polyimide layers are bonded. In the case of laser machining, there is also a restriction that the opening must be in the region where the layer under the polyimide layer 16 is the electrolytic copper plating layer 15.

As a consequence, in the present embodiment, after the pattern formation of the land or electrode by the electrolytic copper plating layer 15 is made fine, the opening 16b corresponding to the land or electrode can be formed highly productively. For example, the opening 16b of the polyimide layer 16a can be easily formed even if the opening is smaller than 0.4 mm in diameter. Hereby, it is possible to pattern the polyimide layer 16a such that separate openings 16b are formed respectively for separate electrical nodes of the fine pattern land or electrode. In this meaning, there is no accuracy restriction in manufacturing a jig for opening processing as in the conventional case of forming the opening in the polyimide layer in advance.

In the conventional case that the polyimide layers on which the openings are formed to correspond to respective lands or electrodes of such a fine pattern are bonded with adhesive resin, when a separator attached on the adhesive resin side of the polyimide layer in advance is detached, the adhesive resin tends to come off from the polyimide layer in that fine portion. For example, such coming off is prominent when a distance between the openings of the polyimide layer is less than 0.25 mm. In such a case, an adhesive failure occurs.

In order to avoid this, the polyimide layer must be structured such that an opening is provided collectively for separate electrical nodes, but this tends to cause short-circuiting of solder between the nodes at the time of component mounting. It is because there is no dam effect for melted solder by the polyimide layer. There is also a structure, for example, in which a res ist material is further provided between the nodes, but this undeniably complicates the process. In the above embodiment, such disadvantages are completely eliminated. In addition, there is no dust generation from a processed end of the polyimide layer.

Though the electrolytic copper plating layer 15 is used as the wiring pattern, flexibility as in a case that rolled copper is used can be ensured by making the thickness thereof considerably thin. Hereby, this wiring board can be applied also to the use in which high flexibility is required. This relates to the fact that the entire wiring board is formed to be thin in a simple layer structure.

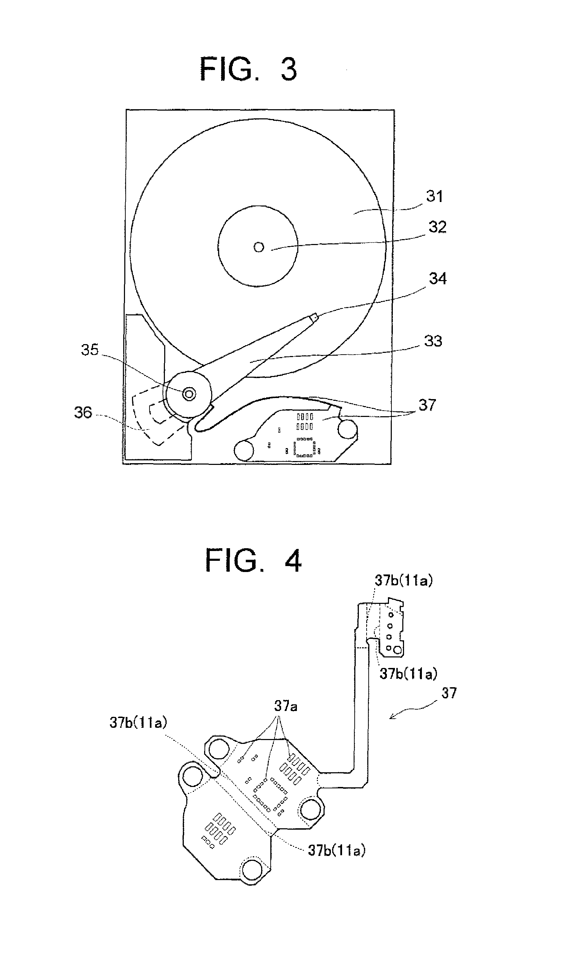

Next, an example of a case that a wiring board according to one embodiment of the present invention is used in a magnetic disc apparatus will be described with reference to Fig. 3. Fig. 3 is a top view showing an aspect in which the wiring board according to the one embodiment of the present invention is used in the magnetic disc apparatus. As shown in Fig. 3, this magnetic disc apparatus includes: a magnetic disc 31; a disc clamper 32; a head carriage 33; a head 34; a pivot 35, a voice coil motor 36; and a head carriage communication wiring board 37. The size as a whole is, for example, 32 mm long and 24 mm wide.

The magnetic disc 31 is a disc-shaped medium retaining information as a magnetic pattern in a circumferential direction, magnetic signals being written/read by the head 34 provided at an end of the head carriage 33 that is displaced in a radial direction of the medium. The disc clamper 32 is for screwing and fixing a rotation center of the magnetic disc 31 to a spindle motor (not shown) side that is provided underneath thereof. The head carriage 33 is for displacing the head 34 provided on its end in the radial direction while keeping the head floated over the magnetic disc 31.

The head 34 is for performing conversion of the electrical signal/magnetic signal to write information into the magnetic disc 31, and conversion of the magnetic signal/electrical signal to read information from the magnetic disc 31. The electrical signals of writing/reading are transmitted bilaterally from the head carriage communication wiring board 37 having a connection to the head carriage 33. The pivot 35 is for supporting the head carriage 33 rotatably as a displacement (rotation) center of the head carriage 33. The voice coil motor 36 is for being a driving source to make the head carriage 33 rotate around the pivot 35.

The head carriage communication wiring board 37 is communicated (connected) to the head carriage 33 and is for transmitting the signals exchanged bilaterally with the head 34. The signal may include a signal to the voice coil motor 36. Additionally, as shown in the drawing, the wiring board has a portion which functions mainly as a cable for signal transmission and whose state of bending changes according to the rotation of the head carriage 33, as well as a region which is continued to the portion in a shape-fixed state and for mainly mounting components (components being not shown).

In such a magnetic disc apparatus, the head carriage communication wiring board 37 is the wiring board according to the embodiment described above. Hereby, in the portion in which the state of bending changes, a degree of load at the time that the head carriage 33 is displaced is smaller due to the thinness thereof as a whole. Additionally, since the stacked structure is simple, structural destruction is hard to occur and reliability is ensured. Further, in the region for mounting components, since the polyimide layer as the cover layer has the opening for each finely disposed land for mounting components, there is effectively reduced the occurrence of the faulty connection such as short-circuitingof solder at the time of mounting components. Hereby, conditions necessary for application to a small-sized magnetic disc apparatus is fulfilled.

Fig. 4 is a top view showing a structure of only the head carriage communication wiring board 37 shown in Fig. 3. As shown in Fig. 4, on some parts of this wiring board 37, a stainless steel layer 37b (i.e. the patterned stainless steel layer 11a in Fig. 2E) is provided. The purpose thereof is to increase mechanical stiffness since flexibility is not required in such regions. Also, in the region for mounting components, lands 37a for mounting components are exposed. Though not shown, between these lands 37a as well as in a portion as a cable to the head carriage 33 side, a wiring pattern by the electrolytic copper plating layer is formed.

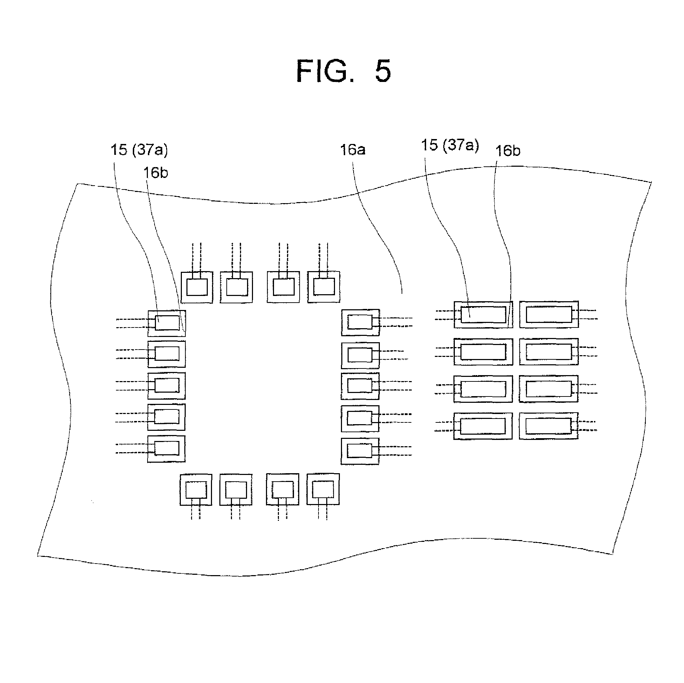

Fig. 5 is a top view enlargedly showing a structure of the component mounting region in the head carriage communication wiring board 37 shown in Fig. 4. As shown in Fig. 5, the respective lands 37a for mounting components are separately exposed by the openings 16b of the polyimide layer 16a of the upper surface. The lands 37a correspond to the electrolytic copper plating layer 15 in Fig. 2E. Since the lands 37a are separately exposed by the openings 16b, the polyimide layer 16a exhibits a function to dam melted solder in the step of mounting components. Hereby, occurrences of fault such as short-circuiting of solder can be effectively reduced.

The present invention is not limited to the specific forms described here with the illustrations, but it is to be understood that all the changes and modifications without departing from the range of the following claims are to be included therein.

## Claims

1. A wiring board, comprising:
a first polyimide layer of heat-cured photosensitive polyimide;
a copper layer pattern formed by growing an electrolytic copper layer on the first polyimide layer; and
a second polyimide layer of heat-cured photosensitive polyimide, the second polyimide layer covering the formed copper layer pattern.

2. A wiring board according to claim 1, further comprising:
a stainless steel layer provided on a surface of the first polyimide layer different from a s ide having the copper layer pattern.

3. A wiring board according to claim 1,
wherein the second polyimide layer includes plural openings to expose a part of the copper layer pattern.

4. A wiring board according to claim 3,
wherein the plural openings of the second polyimide layer respectively are openings for separate electrical nodes in the copper layer pattern.

5. A magnetic disc apparatus, comprising:
a wiring board which comprises: a first polyimide layer of heat-cured photosensitive polyimide, a copper layer pattern formed by growing an electrolytic copper layer on the first polyimide layer, and a second polyimide layer of heat-cured photosensitive polyimide, the second polyimide layer covering the formed copper layer pattern;
a head carriage having an electric connection to the wiring board, and having a head mounted thereon to perform input/output of electric signals transmitted bilaterally via the connection; and
a magnetic disc on which reading/writing of magnetic information are performed by the head mounted on the head carriage.

6. A method of manufacturing a wiring board, comprising:
applying first liquid photosensitivepolyimide on a stainless steel layer by coating;
forming a first polyimide layer of a predetermined shape pattern by exposing, developing, and heat-curing the applied first liquid photosensitive polyimide;
growing an electrolytic copper plating layer of a predetermined pattern on the formed first polyimide layer;
applying a second liquid photosensitive polyimide on the first polyimide layer including the electrolytic copper plating layer of the predetermined pattern by coating; and
forming a second polyimide layer of a predetermined pattern by exposing, developing, and heat-curing the applied second liquid photosensitive polyimide so that a part of the electrolytic copper plating layer is exposed.
